## Europäisches Patentamt

(19) **European Patent Office**

**Office européen des brevets**

(11) Numéro de publication: **0 082 783**
**B1**

(12) # FASCICULE DE BREVET EUROPEEN

(45) Date de publication du fascicule du brevet:
**13.11.85**

(51) Int. Cl.⁴: **H 01 L 21/84,** H 01 L 29/54, H 01 L 29/78

(21) Numéro de dépôt: **82402332.9**

(22) Date de dépôt: **17.12.82**

(54) Procédé de fabrication de transistors en couches minces en silicium sur substrat isolant.

(30) Priorité: **23.12.81 FR 8124118**

(43) Date de publication de la demande:
**29.06.83 Bulletin 83/26**

(45) Mention de la délivrance du brevet:
**13.11.85 Bulletin 85/46**

(84) Etats contractants désignés:
**BE DE GB IT NL SE**

(56) Documents cités:
**DE - A - 2 909 320**
**GB - A - 2 077 039**
**US - A - 4 169 746**

**IEEE ELECTRON DEVICE LETTERS, vol. EDL-1, no. 8, août 1980, pages 159-161, New York, US T.I. KAMINS et al.: "Hydrogenation of transistors fabricated in polycrystalline-silicon films"**
**ELECTRONIC LETTERS, vol. 15, no. 14, 5 juillet 1979, HITCHIN, pages 435-437 A.F. TASCH et al.: "Silicon-on-insulator M.O.S.F.E.T.S. fabricated on laser-annealed polysilicon on SI02"**

(73) Titulaire: **Morin, François, Le Carpont Laumerin, F-22300 Lannion (FR)**
Titulaire: **Favennec, Jean-Luc, 16 Cité du Vallon Saint Quay Perros, F-22700 Perros Guirec (FR)**
Titulaire: **Bonnel, Madeleine, 58 Résidence du Roux, F-22300 Lannion (FR)**

(72) Inventeur: **Morin, François, Le Carpont Laumerin, F-22300 Lannion (FR)**
Inventeur: **Favennec, Jean-Luc, 16 Cité du Vallon Saint Quay Perros, F-22700 Perros Guirec (FR)**
Inventeur: **Bonnel, Madeleine, 58 Résidence du Roux, F-22300 Lannion (FR)**

(74) Mandataire: **Mongrédien, André et al, c/o BREVATOME 25, rue de Ponthieu, F-75008 Paris (FR)**

## Description

La présente invention a pour objet un procédé de fabrication de transistors en couches minces en silicium sur substrat isolant. Elle trouve une application notamment à la réalisation de composants électroniques de grande surface. De tels composants sont utilisés dans la réalisation d'écrans plats d'affichage, de rétines électroniques, de capteurs actifs, de mémoires électroniques etc.

Un transistor en couches minces (T.C.M. en abrégé) est un transistor à effet de champ à grille isolée. Il s'apparente au transistor MOS (Métal-Oxyde-Semiconducteur) avec cette différence qu'il est réalisé sur un substrat amorphe et non sur une plaquette de silicium monocristallin. Comme ils ne sont plus limités par la taille du substrat cristallin, les circuits à T.C.M. peuvent présenter de très grandes dimensions.

Le T.C.M. sur substrat isolant a été étudié par trois voies différentes:

Voie 1:

Avant l'avènement de la technologie MOS sur silicium, un nombre important de travaux rapportaient la fabrication de T.C.M. à base de composés binaires (II-VI) comme CdS et CdSe. Il s'agissait essentiellement de semiconducteurs polycristallins en films minces. Le T.C.M. était obtenu par masquage sous vide. Des variantes récentes ont été proposées incluant des étapes de photogravure. Une de ces variantes cionsiste à effectuer un dépôt uniforme de quatre couches, respectivement de matériaux isolant, semiconducteur, isolant et métallique puis à photograver les trois dernières couches.

Voie 2:

Une deuxième approche, qui date de moins de 5 ans, utilise des monocristaux de silicium sur substrat amorphe, dans le but d'augmenter la compacité des circuits intégrés et si possible de passer en trois dimensions. La recristallisation du silicium est effectuée par laser et divers artifices sont utilisés pour obtenir un monocristal ou un poly-cristal à gros grains. Une fois le silicium recristallisé on utilise pour la fabrication du transistor un processus analogue à la technique MOS, à savoir: implantation, diffusion, oxydation etc. Dans tous les cas, il s'agit d'un processus à haute température, incompatible avec l'utilisation d'un substrat de grande dimension peu cher comme le verre. Le champ d'application est donc restreint à la microélectronique.

Voie 3:

Récemment, des travaux rapportent la réalisation de T.C.M. en silicium amorphe hydrogéné (aSiH), pour la réalisation d'écrans plats à cristaux liquides. Ces T.C.M. sont réalisés par étapes faisant intervenir des photogravures, à partir d'un dépôt de aSiH à basse température (250−300° C). Or, à cette température, le silicium possède un fort taux d'hydrogène (10 à 20%), ce qui nuit à la recristallisation éventuelle du silicium. Cette recristallisation est nécessaire si l'on veut réaliser l'ensemble des circuits de commande de l'écran, en particulier les registres à décalage périphériques (circuit d'adressage du signal vidéo).

Ces trois techniques présentent en outre des inconvénients qui sont les suivants:

Voie 1:

les semiconducteurs composés (II-VI) sont peu fiables, la technique de masquage sous vide est limitée en résolution et en souplesse, et les procédés par photogravure sont complexes. On pourra consulter à ce sujet, l'article de LUO publié dans »IEEE Trans. on Electr. Devices«, vol. ED 27, n° 1, Janvier 1980.

Voie 2:

les procédés à haute température sont limités aux substrats nobles (et chers) comme la silice (cf l'article D. K. Biegelsen et al publié dans »Appl. Phys. Lett« 38 [3], 1er Février 1981).

Voie 3:

la structure proposée est assez complexe, et il y a incompatibilité avec la recristallisation du silicium. On pourra consulter à ce sujet l'article de MATSAMURA publié dans les »Proceedings of the 12th Conference on Solid State Devices«, Tokyo 1980 publiés dans »Japanese Journ. of Appl. Phys.« vol. 20 (1981) supp. 20E, p. 311−314.

Le but de l'invention est justement de remédier à ces inconvénients en proposant un procédé de fabrication simplifié de T.C.M. en silicium amorphe ou polycristallin, sur un substrat de grande dimension, par exemple en verre.

Grâce à l'invention, des T.C.M. en silicium amorphe et en silicium polycristallin ont été obtenus sur un substrat de verre, avec des caractéristiques électriques comparables voire supérieures à celles obtenues par les voies 1 et 3. En outre, un circuit intégré complexe (comprenant jusqu'à $10^5$ T.C.M.) peut être obtenu sur une surface de 1 $dm^2$. Les T.C.M. en silicium amorphe (aSi) et polycristallin (polySi) obtenus par le procédé de l'invention ont un rapport courant de conduction/courant de blocage de l'ordre de $10^4$ avec le silicium amorphe, contre $10^3$ avec le silicium polycristallin. Dans ce dernier cas, la mobilité des porteurs, mesurée par effet de champ, est de l'ordre de 20 $cm^2$/Vs (courant source-drain de 100 µA pour un canal 50 × 100 $\mu m^2$). Ces valeurs peuvent encore être améliorées, notamment en optimisant la recristallisation par laser (ou par tube éclairs). Cependant, même sans cette optimisation, les T.C.M. en aSi obtenus sont bien adaptés à la commande des écrans à cristaux liquides.

Un circuit complexe peut être obtenu, comprenant $320 \times 320$ T.C.M., sur une surface de $8 \text{ cm} \times 8 \text{ cm}$. La matrice obtenue constitue l'une des faces d'une cellule à cristaux liquides, l'autre face étant constituée par une lame de verre vevêtue d'une couche conductrice transparente. Il est possible d'intégrer les circuits d'adressage du signal vidéo à la périphérie de la matrice de transistors. Ces circuits sont constitués de transistors en silicium polycristallin. L'un des intérêts du procédé de fabrication de l'invention est justement de permettre la réalisation simultanée de T.C.M. en aSi et en polySi sur un substrat de verre.

Tous ces résultats sont obtenus selon l'invention par un procédé qui est caractérisé en ce qu'il comprend les opérations suivantes:

— dépôt sur un substrat isolant d'une couche d'un métal apte à former un siliciure au contact de silicium,
— photogravure de cette première couche de métal pour définir les sources, les drains et les canaux pour les futurs transistors et diverses connexions entre transistors,
— dépôt d'une couche de silicium par plasma en phase gazeuse réactive, cette opération provoquant l'apparition d'une couche de siliciure au contact avec le métal de la couche photogravée,
— dépôt d'une couche de silice par plasma en phase gazeuse réactive,
— dépôt d'une couche conductrice par plasma en phase gazeuse réactive,
— photogravure de l'ensemble couche conductrice-couche de silice-couche de silicium, sans attaqe du siliciure qui recouvre la couche de métal photogravée.

Les caractéristiques de l'invention apparaîtront mieux après la description qui suit d'un exemple de réalisation donné à titre explicatif et nullement limitatif. Cette description se réfère à des dessins annexés, qui représentent différentes étapes (a) à (i) du processus de réalisation d'un transistor selon le procédé de l'invention.

Les différentes opérations constituant le procédé de l'invention sont, dans l'exemple illustré, les suivantes:

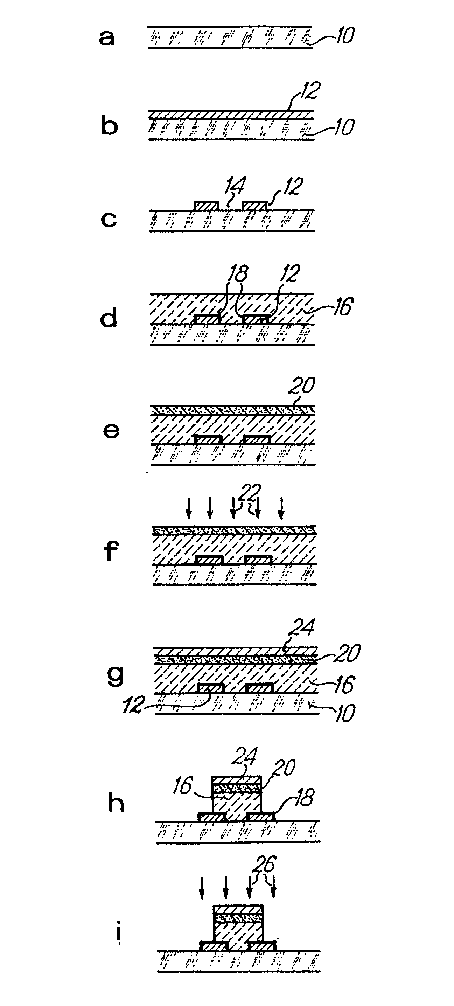

Opérations n° 1:
Préparation d'un substrat de verre (par exemple de la marque Corning 7059); nettoyag physico-chimique classique; sur la figure (a) ce substrat porte la référence 10.

Opération n° 2:
dépôt sur tout le substrat d'une couche 12 de métal, d'épaisseur comprise entre 50 et 200 nm (500 et 2000 Å) et de préférence voisine de 100 nm (1000 Å); ce métal doit servir aux contacts source et drain; un alliage nickel-chrome peut être utilisé, qui forme un siliciure à basse température (400°C) (b).

Opération n° 3:
la couche de Nicr est photogravée pour définir le canal 14 des futurs transistors et les diverses connexions entre les transistors; cette opération nécessite un premier masque et conduit au produit représenté en (c).

Opération n° 4:
dépôt d'une couche de silicium par plasma en phase gazeuse réactive (CVD-plasma) à une température comprise entre 400°C et 600°C et de préférence voisine de 500°C; une couche de siliciure 18 se forme à la surface de la couche 12 photogravée.

Opération n° 5:
dépôt d'une couche de silice 20 par la même méthode, à la même température ou à une température plus basse (e).

Opération n° 6:
dans le cas où on veut obtenir du silicium polycristallin, l'échantillon est alors soumis au rayonnement 22 d'un laser ou d'un tube éclairs, soit in situ (de préférence) soit à l'extérieur du réacteur de dépôt (f).

Opération n° 7:
dépôt d'une couche métallique de grille 24, par exemple en aluminium ou en silicium très dopé, (par CVD plasma), sur toute la surface de l'échantillon (g).

Opération n° 8:
à l'aide d'un second masque on réalise une photogravure du sandwich grille 24-isolant 20-semiconducteur 16, sans attaquer la couche de siliciure 18 formée sur le nickel-chrome (h); cette opération peut être réalisée par voie humide ou sèche; dans cette dernière solution la sélectivité est facile à réaliser. La grille de silicium permet d'effectuer une sous gravure contrôlée du silicium, ce qui diminue le courant de fuite grilledrain et grille-source.

Opération n° 9:
le composant est soumis à une post-hydrogénation (symbolisée par les flèches 26 sur la figure i) pour diminuer le nombre de défauts et améliorer les interfaces. Cette opération s'efectue dans un plasma d'hydrogène à 400°C. La pression d'hydrogène est par exemple de 13,33 Pa (0,1 torr), la puissance RF de 20 W. L'hydrogènation est complète au bout de 15 mn. Bien que les quantités d'hydrogène introduites dans le silicium au cours de cette opération soient faibles (environ 1%), les propriétés électroniques s'en trouvent fortement améliorées: la photoconductivité apparaît, la mobilité est augmentée de plus d'un facteur 10, le nombre de liaisons, pendantes du silicium passe de $10^{19} \text{ cm}^{-3}$ à quelques $10^{16} \text{ cm}^{-3}$.

Opération n° 10:
le composant est ensuite passivé par une couche de $SiO_2$ déposée par CVD plasma et des fenêtres sont éventuellement réalisées pour effectuer les diverses connexions nécessaires à la réalisation du circuit (non représenté).

On observera que le procédé de l'invention est compatible avec les procédés de recristallisation du silicium par rayonnement optique. Sie cette recristallisation est localisée, on peut obtenir à la fois des transistors en silicium amorphe et des transistors en silicium polycristallisé sur le même substrat de verre. Cette faculté est particulièrement intéressante dans la réalisation d'écrans plats d'affichage à électronique de commande intégrée.

**Revendications**

1. Procédé de fabrication de transistors en couches minces sur substrat isolant, caractérisé en ce qu'il comprend les opérations suivantes:

— dépôt sur un substrat isolant (10) d'une couche (12) d'un métal apte à former un siliciure au contact de silicium,
— photogravure de cette première couche de métal pour définir des sources, des drains et des canaux pour les futurs transistors et diverses connexions entre transistors,
— dépôt d'une couche de silicium (16) par plasma en phase gazeuse réactive, cette opération provoquant l'apparition d'une couche de siliciure (18) au contact avec le métal de la couche (12) photogravée,
— dépôt d'une couche de silice (20) par plasma en phase gazeuse réactive,
— dépôt d'une couche conductrice (24) par plasma en phase gazeuse réactive,
— photogravure de l'ensemble couche conductrice (24) couche de silice (20), couche de silicium (16) sans attaque du siliciure (18) qui recouvre la couche de métal photogravée,

2. Procédé selon la revendication 1, caractérisé en ce qu'il comporte en outre les opérations suivantes:

— posthydrogénation de l'ensemble dans un plasma d'hydrogène,
— passivation de l'ensemble par une couche de silice déposée par plasma en phase gazeuse réactive.

3. Procédé selon la revendication 1, caractérisé en ce que la couche conductrice (24) est en métal.
4. Procédé selon la revendication 3, caractérisé en ce que la couche conductrice (24) est en aluminium.
5. Procédé selon la revendication 1, caractérisé en ce que la couche conductrice (24) est en silicium très dopé et est obtenue par plasma en phase gazeuse réactive.
6. Procédé selon la revendication 1, caractérisé en ce que le métal de la couche (12) déposée sur le substrat (10) est en alliage nickel-chrome.
7. Procédé selon la revendication 6, caractérisé en ce que la couche (12) de nickel-chrome a une épaisseur comprise entre 50 nm (500 Å) et 150 nm (1500 Å) et de préférence voisine de 100 nm (1000 Å).

8. Procédé selon la revendication 1, caractérisé en ce que la couche de silicium (16) a une épaisseur comprise entre 300 nm (3000 Å) et 700 nm (7000 Å) et de préférence voisine de 500 nm (5000 Å).

9. Procédé selon l'une quelconque des revendications 1 à 8, caractérisé en ce que l'opération de dépôt de silicium s'effectue à une température comprise entre 350° C et 650° C et de préférence à une température voisine de 500° C.

10. Procédé selon l'une quelconque des revendications 1 à 9, caractérisé en ce que l'opération de dépôt de la couche de silice (20) est suivie d'une opération d'insolation de l'ensemble par un rayonnement optique apte à provoquer une recristallisation du silicium (16).

11. Procédé selon la revendication 2, caractérisé en ce que la posthydrogénation est effectuée dans un plasma d'hydrogène à une température comprise entre 300° C et 500° C et de préférence voisine de 400° C.

**Patentansprüche**

1. Verfahren zur Herstellung eines Transistors aus einem auf einem isolierenden Substrat aufgebrachten Dünnfilm, gekennzeichnet durch die folgenden Schritte:

— auf dem isolierenden Substrat (10) wird eine Schicht (12) aus einem Metall aufgebracht, welches in der Lage ist, bei Kontakt mit Silizium eine Siliziummetallverbindung einzugehen;
— durch Photoätzen dieser ersten Schicht werden Source, Drain und die Kanäle für die zukünftigen Transistoren und verschiedene Anschlüsse unter den Transistoren erzeugt;
— eine Siliziumschicht (16) wird als Plasma in reaktiver Gasphase aufgetragen, was zur Folge hat, daß an der photogeätzten Schicht (12) beim Kontakt mit dem Metall eine Siliziummetallverbindung (18) entsteht;
— das Auftragen einer Siliziumoxidschicht (20) als Plasma in einer reaktiven Gasphase;
— das Auftragen einer leitenden Schicht (24) als Plasma in reaktiver Gasphase;
— das gemeinsame Photoätzen der leitenden Schicht (24), der Siliziumoxidschicht (20) und der Siliziumschicht (16), ohne daß dabei die Siliziummetallverbindung (18), die die photogeätzte Metallschicht abdeckt, angegriffen wird.

2. Verfahren nach Anspruch 1, gekennzeichnet durch die weiteren Schritte:

— nachfolgende Hydrierung der Anordnung in einem Wasserstoffplasma,
— Passivierung der Anordnung durch eine Siliziumoxidschicht, die als Plasma in reaktiver Gasphase aufgetragen wird.

3. Verfahren nach Anspruch 1, dadurch gekennzeichnet, daß die leitende Schicht (24) aus Metall besteht.

4. Verfahren nach Anspruch 3, dadurch gekennzeichnet, daß die leitende Schicht (24) aus Aluminium besteht.

5. Verfahren nach Anspruch 1, dadurch gekennzeichnet, daß die leitende Schicht (24) aus einem hochdotierten Silizium besteht, und durch Plasmaauftragung in einer reaktiven Gasphase erhalten wird.

6. Verfahren nach Anspruch 1, dadurch gekennzeichnet, daß die Metallschicht (12), die auf das Substrat (10) aufgetragen ist, aus einer Nikkelchromverbindung besteht.

7. Verfahren nach Anspruch 6, dadurch gekennzeichnet, daß die Nickelchromschicht eine Dicke zwischen 50 nm (500 Å) und 150 nm (1500 Å) und vorzugsweise in der Nähe von 100 nm (1000 Å) besitzt.

8. Verfahren nach Anspruch 1, dadurch gekennzeichnet, daß die Siliziumschicht (16) eine Dicke zwischen 300 nm (3000 Å) und 700 nm (7000 Å) und vorzugsweise in der Nähe von 500 nm (5000 Å) besitzt.

9. Verfahren nach irgendeinem der Ansprüche 1 bis 8, dadurch gekennzeichnet, daß der Schritt zur Aufbringung des Siliziums in einem Temperaturbereich zwischen 250°C und 650°C und vorzugsweise bei einer Temperatur in der Nähe von 500°C durchgeführt wird.

10. Verfahren nach irgendeinem der Ansprüche 1 bis 9, dadurch gekennzeichnet, daß nach dem Aufbringen der Siliziumoxidschicht (20) eine Isolierung der Anordnung vorgenommen wird, wobei die Anordnung einer optischen Strahlung ausgesetzt wird, die in der Lage ist, eine Rekristallisation des Siliziums (16) hervorzurufen.

11. Verfahren nach Anspruch 2, dadurch gekennzeichnet, daß die Nachhydrierung in einem Wasserstoffplasma bei einer Temperatur zwischen 300 und 500°C und vorzugsweise in der Nähe von 400°C vorgenommen wird.

## Claims

1. Process for manufacturing silicon thin film transistors on an insulating substrate, characterised in that it comprises the following operations:

— depositing a film (12) of metal on an insulating substrate suitable to form a silicide on contact with silicon,
— photo-engraving this first metal film for defining the sources, drains, and channels for the future transistors, and diverse connections between transistors,
— depositing a film of silicon (16) from plasma in a reactive gaseous phase, this operation causing the appearance of a film of silicide (18) on contact with the photo-engraved metal film (12),
— depositing a film of silica (20) from plasma in a reactive gaseous phase,
— depositing a conductive film (24) from plasma in a reactive gaseous phase,
— photo-engraving the whole of the conductive film (24), silica film (20), silicon film (16) without attacking the silicide (18) which covers the photo-engraved metal film.

2. Process according to claim 1, characterised in that it comprises in addition the following operations:

— post hydrogenation of the whole in a hydrogen plasma,
— passivation of the whole by a silica film deposited from plasma in a reactive gaseous phase.

3. Process according to claim 1, characterised in that the conductive film (24) is metal.

4. Process according to claim 3, characterised in that the conductive film (24) is aluminium.

5. Process according to claim 1, characterised in that the conductive film (24) is made of highly doped silicon and is obtained from plasma in a reactive gaseous phase.

6. Process according to claim 1, characterised in that the metal of the film (12) deposited on the substrate (10) is a nickel-chrome alloy.

7. Process according to claim 6, characterised in that the nickel-chrome film (12) is of a thickness of between 50 nm (500 Å) and 150 nm (1500 Å) and preferably in the vicinity of 100 nm (1000 Å).

8. Process according to claim 1, characterised in that the silicon film (16) is of a thickness between 300 nm (3000 Å) and 700 nm (7000 Å) and preferably in the vicinity of 500 nm (5000 Å).

9. Process according to any of claims 1 to 8, characterised in that the operation of depositing the silicon is effected at a temperature of between 350°C and 650°C und preferably at a temperature in the vicinity of 500°C.

10. Process according to any of claims 1 to 9, characterised in that the operation of depositing the silica film (20) is followed by an insulation operation of the whole by means of optical radiation suitable to cause recrystalisation of the silicon (16).

11. Process according to claim 2, characterised in that post hydrogenation is effected in a hydrogen plasma at a temperature of between 300°C and 500°C and preferably in the vicinity of 400°C.